# EUROPEAN PATENT SPECIFICATION

(11) **EP 4 178 099 B1**
(45) Date of publication and mention of the grant of the patent: **19.06.2024**
(21) Application number: 20944548.5
(22) Date of filing: 06.07.2020
(51) Int. Cl.: H02N 2/18, H01H 13/14

(54) **SELF-GENERATING DEVICE**
SELBSTERZEUGENDE VORRICHTUNG
DISPOSITIF AUTO-GÉNÉRATEUR

(43) Date of publication of application: 10.05.2023
(73) Proprietor: Wu, Wenjing, Shenzhen, Guangdong 518000 (CN)
(72) Inventor: HUANG, Yu, Shenzhen, Guangdong 518000 (CN); WU, Wenjing, Shenzhen, Guangdong 518000 (CN)
(74) Representative: Puchberger & Partner Patentanwälte
(86) International application number: PCT/CN2020/100365
(87) International publication number: WO 2022/006692

(56) References cited:
- WO-A1-2018/056059
- CN-A- 106 327 822
- CN-A- 109 742 972
- CN-A- 109 742 972
- CN-A- 110 353 432
- CN-A- 110 353 432
- CN-U- 201 956 927
- US-A1- 2014 252 918
- US-B2- 10 135 365

## Description

### TECHNICAL FIELD

The present application relates to the field of self-generation device technologies, and more particularly to a self-generation device.

### BACKGROUND

The statements herein only provide background information relevant to the present application and are not necessarily constituted as prior art.

A wide variety of piezoelectric power generation devices are available in the market currently, these power generation devices are favorable due to their characteristics including simple structures and few components. However, most of the piezoelectric power generation devices have lower power generation efficiency and have small amount of electric energy production converted from mechanical energy. It is difficult for these power generation devices to meet the demand of self-generation applications. For example, a prior art document CN109742972A provides a piezoelectric ceramic power generation device and method. The device includes an elastic piezoelectric ceramic piece, a driving mechanism and a switching device, when an external acting force is applied to the driving mechanism, the driving mechanism transfers the external acting force to the switching device; when the force applied to the switching device is less than a first preset force, the switching device is deformed within a preset range; when the force applied to the switching device is greater than the first preset force, the switching device acts quickly to impact the elastic piezoelectric ceramic piece, and thus the elastic piezoelectric ceramic piece generates electric energy. According to the piezoelectric ceramic power generation device and method, more power can be generated A further example of prior art may be found in CN110353432.

### SUMMARY

One objective of the embodiments of the present application is to provide a self-generation device, which aims to solve the problem that the piezoelectric power generation devices have lower power generation efficiencies, have small amount of electric energy productions, and thus cannot meet the demand of self-generation applications.

In order to solve the above-mentioned technical problem, the technical solutions used in the embodiments of the present application are described as follows:
A self-generation device, including:
a piezoelectric patch, a bottom of the piezoelectric patch is provided with a deformation space for accommodating the deformed piezoelectric patch;
a vibration structure including an elastic element and a mass block connected to the elastic element; and
a vibration trigger structure which has a trigger threshold and is resilient; the vibration trigger structure is arranged between the piezoelectric patch and the mass block, and a bottom surface of the mass block is in contact with the vibration trigger structure;
a central part of the vibration trigger structure is provided with an arc-shaped protrusion. The arc-shaped protrusion is deformable when the mass block is pressed against the vibration trigger structure. The arc-shaped protrusion makes a deformational displacement when the applied force exerted on the arc-shaped protrusion reaches the trigger threshold, and then is rebounded upwards when the applied force is released, thereby generating;
the vibration trigger structure is a metal elastic sheet suspended above the piezoelectric patch, the metal elastic sheet is bent in a direction away from the piezoelectric patch so as to form a second convex bump, a central part of the second convex bump is bent towards the piezoelectric patch so as to form the arc-shaped protrusion, and the arc-shaped protrusion is in contact with the piezoelectric patch.

The elastic element is capable of driving the vibration trigger structure to press against the piezoelectric patch through the mass block after receiving a force. When a driven force exerted on the vibration trigger structure is greater than the trigger threshold, the vibration structure generates vibrations, so that the piezoelectric patch receives an alternating load and generates multiple deformations in the deformation space in order to convert a mechanical energy generated due to vibrations of the mass block into an electrical energy.

In one embodiment, the vibration trigger structure is a metal dome fixed to a top surface of the piezoelectric patch. The arc-shaped protrusion is formed at a central part of the metal dome, and the arc-shaped protrusion is curved in a direction away from the piezoelectric patch and abuts against the bottom surface of the mass block.

In one embodiment, the vibration trigger structure is a metal elastic sheet suspended above the piezoelectric patch. The metal elastic sheet is bent in a direction away from the piezoelectric patch so as to form a first convex bump, and a central part of the first convex bump is bent in a direction away from the piezoelectric patch so as to form the arc-shaped protrusion.

In one embodiment, a position of the bottom surface of the mass block corresponding to of the arc-shaped protrusion is provided with a lug boss, the lug boss has a cross-sectional area smaller than a cross-sectional area of a widest part of the arc-shaped protrusion.

In one embodiment, a cross-section of the piezoelectric patch in a thickness direction is circular, a central axis of the piezoelectric patch, a central axis of the elastic element and a central axis of the vibration trigger structure are coincided.

In one embodiment, the elastic element includes a first spring, a bottom end of the first spring is fixed to a top surface of the mass block, and a central axis of the first spring is coincided with a central axis of the mass block.

In one embodiment, the elastic element further includes a stressed member which is resilient after being pressed, a top end of the first spring is engaged with a bottom surface of the stressed member. The stressed member drives the first spring to be deformed after being pressed, and the first spring drives the mass block to perform a damped vibration under an action of an elasticity thereof, after the force applied on the stressed member is released.

In one embodiment, a bottom surface of the stressed member is provided with a convex block, and the top end of the first spring is sleeved on and secured to an outer circumference of the convex block.

In one embodiment, the self-generation device further includes a housing, the stressed member is arranged on a top surface of the housing, the piezoelectric patch and the vibration structure are received in the housing. An inner bottom surface of the housing is provided with a mounting base, the mounting base is recessed, so that a recess is formed. A periphery of the piezoelectric patch is fixed on the mounting base, and a wall of the recess and the piezoelectric patch are enclosed to form the deformation space.

In one embodiment, the stressed member is a force panel arranged on the top surface of the housing, and the force panel is resilient.

In one embodiment, the stressed member is a button arranged on the top surface of the housing, and a resilient elastic element for restoration of the button after the button is pressed is provided between the button and the housing.

In one embodiment, the elastic element comprises a plurality of second springs, one end of each of the plurality of second springs is connected to the mass block, and the plurality of second springs are distributed horizontally or diagonally upwards. The plurality of second springs are arranged to be distributed uniformly around a circumference of the mass block.

In one embodiment, the mass block is a metal block or a cement block.

Another technical solution used in the embodiments of the present application is self-generation device, including:
a piezoelectric patch, a bottom of the piezoelectric patch is provided with a deformation space for accommodating the piezoelectric patch after being deformed;
a vibration structure including a mass block, the mass block is arranged above the piezoelectric patch; and
a vibration trigger structure which has a trigger threshold and is resilient. The vibration trigger structure includes an elastic element and a lever, one end of the elastic element is connected to the mass block, one end of the lever is connected to a top surface of the mass block. When a driving force exerted on the other end of the lever is greater than the trigger threshold, the lever is rotated around a pivot point and drives the mass block to move upwards. After the driving force exerted on the other end of the lever is released, the lever and the elastic element drive the mass block to generate vibrations, so that the piezoelectric patch receives an alternating load and generates multiple deformations in the deformation space in order to convert a mechanical energy generated due to the vibrations of the mass block into an electrical energy. The elastic element is configured to enable the mass block to restore to its original position after the vibrations of the mass block disappear.

In one embodiment, the self-generation device further includes a metal dome fixed to a top surface of the piezoelectric patch. A central part of the metal dome is protruded towards the mass block and forms an arc-shaped protrusion that abuts against the mass block. The arc-shaped protrusion makes a deformational displacement when an applied force exerted on the arc-shaped protrusion reaches the trigger threshold, and is rebounded upwards when the applied force is released.

In the self-generation device according to the embodiments of the present application, according to the arrangement of the vibration structure, the elastic element of the vibration structure can drive the vibration trigger structure through the mass block after receiving an applied force. When the driving force exerted on the vibration trigger structure is greater than the trigger threshold, vibrations are generated. Then, the piezoelectric patch generates multiple deformations in the deformation space, so that the mechanical energy generated due to the vibrations of the mass block can be converted into electrical energy. As compared to a single-use pressing structure, the vibration structure can enable the piezoelectric patch to generate multiple deformations, so that the electric energy production is greatly increased.

### BRIEF DESCRIPTION OF THE DRAWINGS

In order to describe the embodiments of the present application more clearly, a brief introduction regarding the accompanying drawings that need to be used for describing the embodiments or exemplary technologies is given below.
FIG. 1 illustrates a schematic structural diagram of a self-generation device which is not part of the present application;
FIG. 2 illustrates a schematic structural diagram of a vibration structure of the self-generation device as shown in FIG. 1;
FIG. 3 illustrates a schematic lateral view of a part of the self-generation device which is not part of the present application;
FIG. 4 illustrates a schematic top view of a part of the self-generation device as shown in FIG. 3;
FIG. 5 illustrates a schematic lateral view of a part of the self-generation device according to another embodiment of the present application;
FIG. 6 illustrates a schematic structural diagram of a vibration structure in the self-generation device according to another embodiment of the present application;
FIG. 7 illustrates a schematic structural diagram of a vibration structure in the self-generation device according to yet another embodiment of the present application;
FIG. 8 illustrates a schematic exploded view of the self-generation device which is not part of the present application;
FIG. 9 illustrates a schematic structural diagram of a surface shell in the self-generation device as shown in FIG. 8;
FIG. 10 illustrates a schematic diagram of an output waveform of an existing piezoelectric patch using a single-use pressing structure after deformation, and a waveform after rectification and collection.
FIG. 11 illustrates a schematic diagram of an output waveform of the piezoelectric patch after occurrence of vibration of the used self-generation device shown in FIG. 1, and the waveform after rectification and collection.
FIG. 12 illustrates a schematic structural diagram of a self-generation device according to one embodiment of the present application;
FIG. 13 illustrates a schematic structural diagram of the self-generation device as shown in FIG. 12 when a vibration trigger structure is triggered;
FIG. 14 illustrates a schematic structural diagram of a self-generation device according to another embodiment of the present application; and
FIG. 15 illustrates a schematic structural diagram of the self-generation device as shown in FIG. 14 when the vibration trigger structure is triggered.

Reference numerals in the figures are listed below:
100-piezoelectric patch; 200-vibration mechanism; 300-vibration trigger structure; 400-housing; 210-elastic element; 220-mass block; 211-first spring; 212-second spring; 221-accommodation groove; 222-lug boss; 310-metal dome; 320-metal elastic sheet; 321-first convex bump; 322-second convex bump; 323-arc-shaped protrusion; 330-elastic element; 340-lever; 410-surface shell; 420-bottom shell; 430-mounting base; 440-circuit board; 411-stressed member; 412-force panel; 413, convex block; 431-recess.

### DETAILED DESCRIPTION OF THE EMBODIMENTS

Herein, embodiments of the present application are described in detail, and examples of the embodiment are illustrated in the accompanying figures; wherein, an always unchanged reference number or similar reference numbers represent(s) identical or similar components or components having identical or similar functionalities. The embodiment described below with reference to the accompanying figures is illustrative and intended to illustrate the present application, but should not be considered as any limitation to the present application.

In the description of the present application, it needs to be understood that, directions or location relationships indicated by terms such as "length", "width", "up", "down", "front", "rear", "left", "right", "vertical", "horizontal", "top", "bottom", "inside", "outside", and so on are the directions or location relationships shown in the accompanying figures, and are only intended to describe the present application conveniently and are for the purpose of conciseness of the description, but should not be interpreted as indicating or implying that a device or a component indicated by the terms must have specific locations and be constructed and manipulated according to the specific locations. Therefore, these terms shouldn't be considered as limitation to the present application.

In order to describe the technical solutions of the present application, the present application are described in detail below with reference to accompanying figures and embodiments.

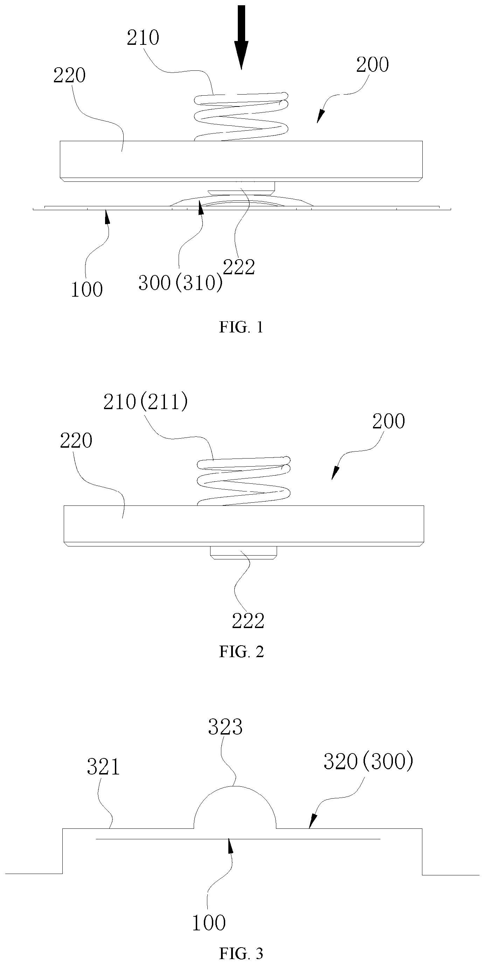

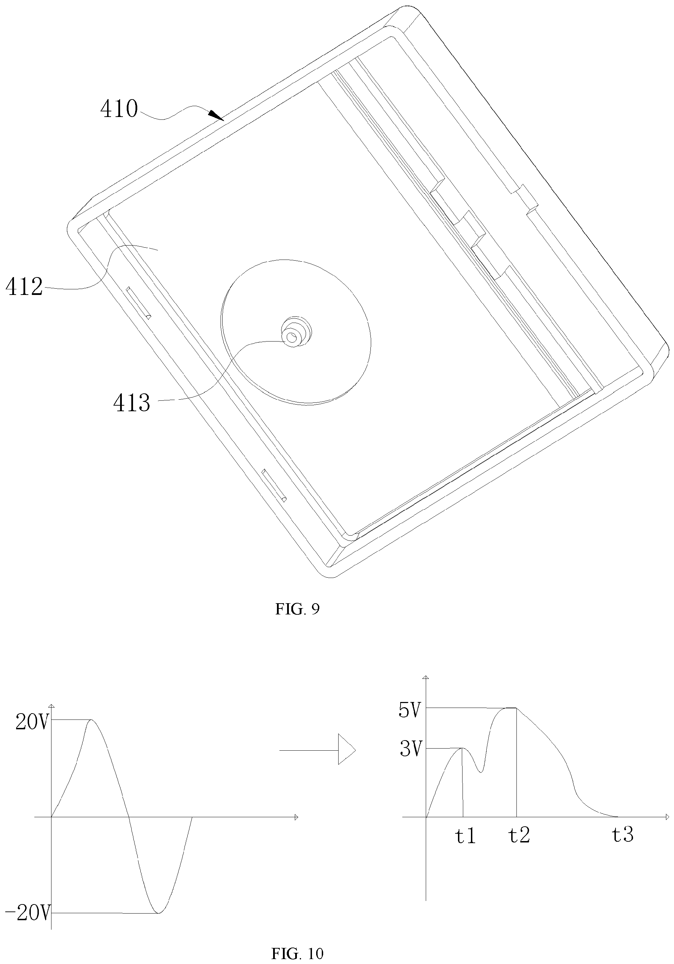

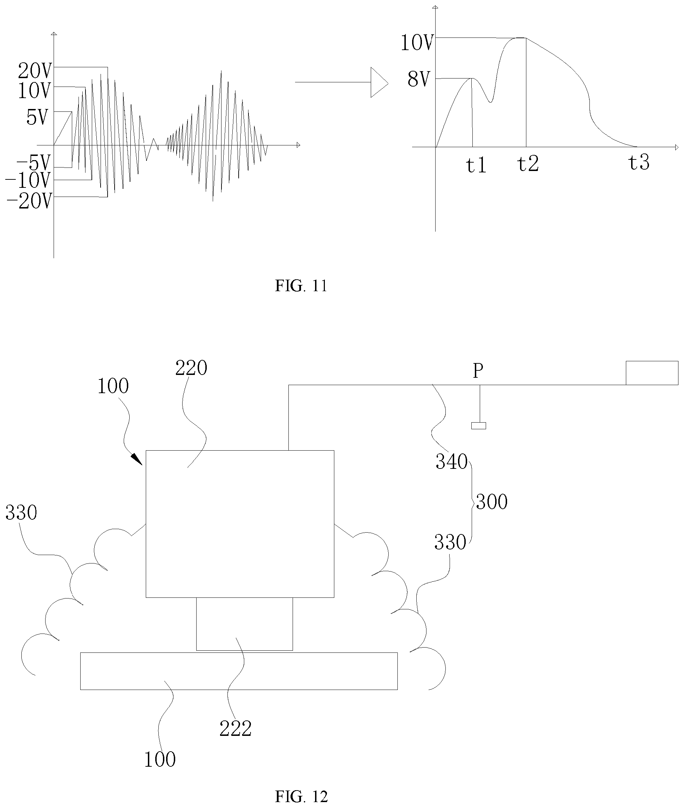

Referring to FIG. 1 and FIG. 2, the self-generation device in this example, which is not part of the invention includes a piezoelectric patch 100, a vibration structure 200, and a vibration trigger structure 300. The piezoelectric patch 100 is a material that generates electrical energy by deformation after being pressed. The piezoelectric patch 100 may be made of a material including but not limited to a piezoelectric ceramic sheet, or be made of a material such as terbium dysprosium iron or iron gallium. A bottom of the piezoelectric patch 100 has a deformation space for accommodating the deformed piezoelectric patch 100. The vibration structure 200 includes an elastic element 210 and a mass block 220 connected with the elastic element 210, the vibration trigger structure 300 has a trigger threshold and is resilient when it is pressed. The vibration trigger structure 300 is arranged between the piezoelectric patch 100 and the mass block 220, and a bottom surface of the mass block 220 is in contact with the vibration trigger structure 300. The elastic element 210 can drive the vibration trigger structure 300 through the mass block 220 after receiving a force, so that the vibration trigger structure 300 is abutted against the piezoelectric patch 100. When a driving force exerted on the vibration trigger structure 300 is greater than the trigger threshold, the vibration structure 200 generates vibrations and causes the vibration trigger structure 300 to be pressed against the piezoelectric patch 100, so that the piezoelectric patch 100 receives an alternating load and generates multiple deformations in the deformation space, and the mechanical energy generated due to vibrations of the mass block 220 can be converted into electrical energy. In other words, the force in a direction shown by the arrow in FIG. 1 is exerted on the elastic element 210, the elastic element 210 can drive the mass block 220 to perform a damped vibration after receiving the force. The mass block 220 moves up and down repeatedly, during this process, vibrations are generated by repeatedly pressing the vibration trigger structure 30 against the piezoelectric patch 100, so that the piezoelectric patch 100 generate multiple deformations in the deformation space, until the mass block 220 stops movement. During the vibration process, the mechanical energy generated due to the vibrations of the mass block 220 is converted into electrical energy, and the electrical energy generated due to the multiple deformations of the piezoelectric patch 100 can be output to an energy storage device through wires. Under the same pressing force and according to the use of the piezoelectric patch 100 with the same specification, the piezoelectric patch 100 in this example generates multiple deformations and can generate twice or even multiple times of electric energy than the existing piezoelectric patch 100, thereby greatly improving the power generation efficiency and the electric energy production. As shown in Fig. 10, a waveform of an output of the piezoelectric patch 100 using the single-use pressing structure (i.e., vibration is not generated) is shown on the left, and the waveform after rectification and collection, that is, the rectified and collected waveform that can be used for effective power generation is shown on the right. As shown in Fig. 11, the waveform of the output of the piezoelectric patch 100 after vibration generation using the self-generation device of this embodiment is shown on the left, and the waveform after rectification and collection is shown on the right. As shown in FIG. 11, the waveform output by the piezoelectric patch 100 after vibration of the self-generation device in this embodiment is shown on the left, the waveform after rectification and collection is shown on the right, it can be seen from the comparison between FIG. 10 and FIG. 11 that, the electric energy generated by the self-generation device having the vibration structure and a vibration trigger structure 300 in this embodiment is much greater than the electric energy generated by the conventional self-generation device.

In the self-generation device according to this example, by arranging the vibration structure 200, the elastic element 210 of the vibration structure 200 can drive the vibration trigger structure 300 through the mass block 220 after receiving an applied force. When the driving force exerted on the vibration trigger structure 300 is greater than the trigger threshold, vibrations are generated. Then, the piezoelectric patch 100 generates multiple deformations in the deformation space, so that the mechanical energy generated due to the vibrations of the mass block 220 can be converted into electrical energy. As compared to a single-use pressing structure, the vibration structure 200 can enable the piezoelectric patch 100 to generate multiple deformations, so that the electric energy production is greatly increased.

In one embodiment, referring to FIG. 1, FIG. 3 and FIG. 5, a central part of the vibration trigger structure 300 is provided with an arc-shaped protrusion 323. The arc-shaped protrusion 323 may be a protrusion curved upwards or downwards, and the arc-shaped protrusion 323 can be in contact with the bottom surface of the mass block 220. As an alternative, the arc-shaped protrusion 323 and the bottom surface of the mass block 220 can be spaced apart from each other. The arc-shaped protrusion 323 can be deformed when the mass block 220 is pressed against the vibration trigger structure 300, and the arc-shaped protrusion 323 can make a deformational displacement when the force exerted on the arc-shaped protrusion 323 reaches the trigger threshold, that is, the arc-shaped protrusion 323 makes a momentary deformational displacement, and the arc-shaped protrusion 323 can be rebounded upward when the applied force is released, so that a force that causes the mass block 220 to generate vibrations at an equilibrium point is provided.

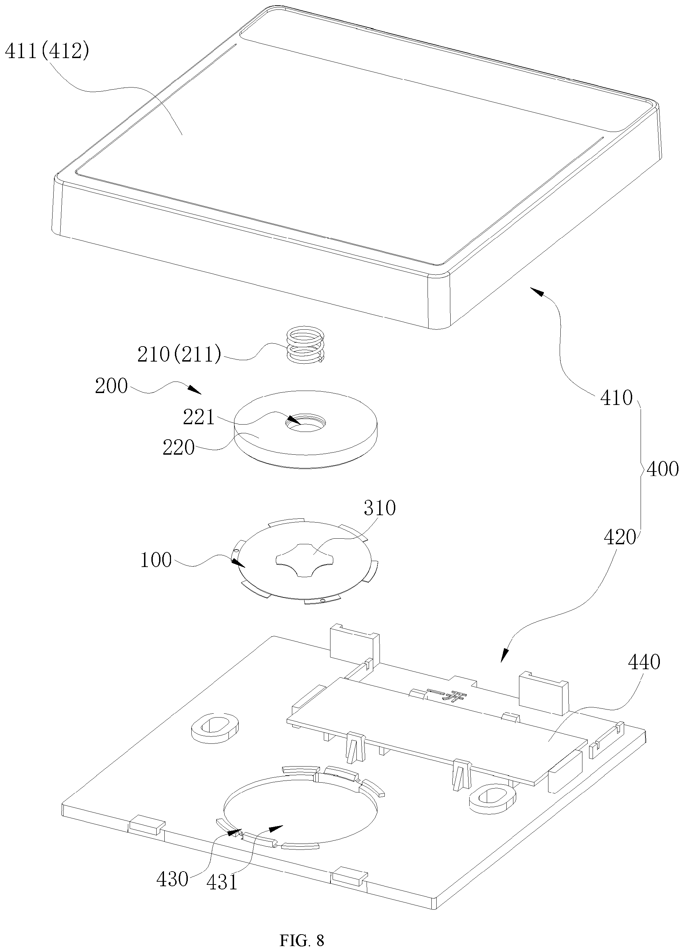

In one example, not part of the invention, referring to FIGS. 1 and 8, the vibration trigger structure 300 is a metal dome 310 fixed to the top surface of the piezoelectric patch 100, a center axis of the metal dome 310 is coincided with a center axis of the piezoelectric patch 100, that is, the metal dome 310 is arranged at a central part of the top surface of the piezoelectric patch 100. The metal dome 310 includes an integrally shaped connection part and an arc-shaped protrusion 323, the connection part is fixed to the top surface of the piezoelectric patch 100 in a certain manner (e.g., bonding). The connection part includes a plurality of connection feet arranged annularly and at intervals, one end of each connection foot is fixed to the top surface of the piezoelectric patch 100 and the other end of the connection foot is connected to a circumference of the arc-shaped protrusion 323. The plurality of connection feet are arranged to be distributed on the circumference of the arc-shaped protrusion 323 evenly and at intervals. The arc-shaped protrusion 323 is bent in a direction away from the piezoelectric patch 100. The metal dome 310 has a trigger threshold, when the force applied on the arc-shaped protrusion 323 is greater than the trigger threshold, the metal dome 310 generates effective deformation, after the applied force is released, the arc-shaped protrusion 323 of the metal dome 310 is rebounded to its original state in the reverse direction. It can be understood that the metal dome 310 can also be in other shapes, the shape of the metal dome 310 is not limited to the shape of the cross-shaped metal dome 310 shown in FIG. 8. The diameter and the pressing force (i.e., the trigger threshold) of the metal dome 310 can be set according to the performance parameters of the piezoelectric patch 100 and the actual application needs of the self-generation device.

After the elastic element 210 is stressed, the process of changing of the state of the metal dome 310 is described below: when the force exerted on the metal dome 310 through the mass block 220 exceeds the trigger threshold, the metal dome 310 enters a sudden change state from a stable state, that is, when the applied force exceeds the trigger threshold, a sudden deformation occurs, so that the vibration structure 200 generates vibrations. Then, when the applied force is weakened to a restoration threshold, the elastic element 210 will restore to its original position, and vibrations are generated again. The mechanical energy generated by the mass block 220 due to the first vibration is the greatest, after the applied force disappears, the mechanical energy generated due to the vibration of the mass block 220 gradually decreases until the vibration disappears. In other words, the greatest electrical energy is produced due to the first vibration of the mass block 220, then, the produced electrical energy is gradually weakened. An energy storage process is completed during the occurrence of the sudden deformation of the metal dome 310, after the energy storage is completed by the metal dome 310, the energy storage is directly transmitted to the piezoelectric patch 100 to generate vibrations. When the piezoelectric patch 100, the metal dome 310, the elastic element 210 and the mass block 220 have been arranged, the mass block 220 generates vibrations after the elastic element 210 is pressed, the mass block 220 can move back and forth for more than 10 times, that is, the piezoelectric patch 100 generates more than 10 times of deformations in the deformation space, so that the electric energy production is greatly increased.

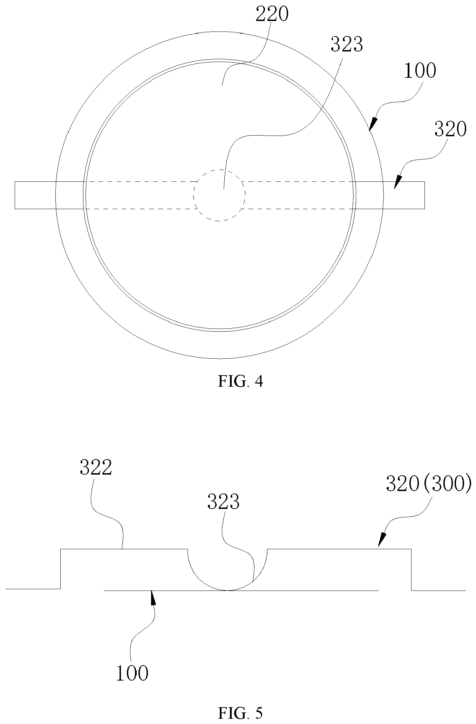

In one example, not part of the invention, referring to FIG. 3 and FIG. 4, the vibration trigger structure 300 is a metal elastic sheet 320 suspended above the piezoelectric patch 100, the metal elastic sheet 320 is bent in a direction away from the piezoelectric patch 100 and forms a first convex bump 321, and a central part of the first convex bump 321 is bent in a direction away from the piezoelectric patch 100 to form the arc-shaped protrusion 323. As shown in FIG. 4, the metal elastic sheet 320 is in a strip shape, the piezoelectric patch 100 is in a circular shape, the metal elastic sheet 320 is suspended above the piezoelectric patch 100 and is spaced from the piezoelectric patch 100. The metal elastic sheet 320 spans the piezoelectric patch 100, a length direction of the metal elastic sheet 320 is parallel to a radial direction of the piezoelectric patch 100. The middle part of the metal elastic sheet 320 is provided with an upwardly curved first convex bump 321, a diameter of the bottom of the first convex bump 321 is greater than a width of the metal elastic sheet 320. The bottom surface of the mass block 220 abuts against the first convex bump 321. When the mass block 220 is pressed against the first convex bump 321 and the applied force is greater than the trigger threshold of the first convex bump 321, the bottom surface of the metal elastic sheet 320 is pressed against the piezoelectric patch 100, and the piezoelectric patch 100 is deformed. After the applied force is released, the mass block 220 generates vibrations. The metal elastic sheet 320 is continuously pressed against the piezoelectric patch 100, so that the piezoelectric patch 100 generates multiple deformations, and the mechanical energy generated by the vibration is converted into electrical energy.

In another embodiment, referring to FIG. 5, the vibration trigger structure 300 is a metal elastic sheet 320 suspended above the piezoelectric patch 100, and the metal elastic sheet 320 is bent in the direction away from the piezoelectric patch 100 to form a second convex bump 322, and a central part of the second convex bump 322 is bent towards the piezoelectric patch 100 to form the arc-shaped protrusion 323 which is in contact with the piezoelectric patch 100. The arrangement of this metal elastic sheet 320 in this embodiment is the same as the arrangement of the metal elastic sheet 320 in the previous example, what is different from the previous example is that the second convex bump 322 is bent downwards, the second convex bump 322 is in an initial position when the applied force is not exerted on the mass block 220, that is, the second convex bump 322 is in contact with the piezoelectric patch 100 when it is in the initial position, and the bottom surface of the mass block 220 abuts against the top surface of the metal elastic sheet 320. The mass block 220 is pressed against the top surface of the metal elastic sheet 320, so that the second convex bump 322 generates deformations. When the applied force exceeds the trigger threshold of the second convex bump 322, the second convex bump 322 can be resiliently rebounded to its original position, the mass block 220 generates vibrations. Then, the mass block 220 generates damped vibrations, and the second convex bump 322 is repeatedly pressed against the piezoelectric patch 100 to cause the piezoelectric patch 100 to generate multiple deformations.

It should be understood that, the overall shape of the metal elastic sheet 320 may not be limited to the strip shape in the aforesaid embodiment. Instead, the metal elastic sheet 320 may also be in other shape, such as circular shape, cross-shape, asterisk-shape, star-shape, and other regular geometric shape.

In one embodiment, referring to FIG. 1 and FIG. 2, when the arc-shaped protrusion 323 is bent upwards, a position of the bottom surface of the mass block 220 corresponding to the arc-shaped protrusion 323 is convexly provided with a lug boss 222, the cross-sectional area of the lug boss 222 is smaller than the cross-sectional area of the widest part of the arc-shaped protrusion 323. The lug boss 222 can be arranged to be in a cylindrical shape. Referring to FIG. 1 and FIG. 3, the lug boss 222, the arc-shaped protrusion 323 and the mass block 220 are arranged coaxially, and a bottom surface of the lug boss 222 abuts against the arc-shaped protrusion 323 of the metal dome 310. When the arc-shaped protrusion 323 is bent downwards, it is unnecessary to arrange the lug boss 222 at the bottom surface of the mass block 220.

In one embodiment, referring to FIG. 1 and FIG. 4, the cross section of the piezoelectric patch 100 in the thickness direction is circular, and the central axis of the piezoelectric patch 100, the central axis of the elastic element 210 and the central axis of the vibration trigger structure 300 are coincided. It can be understood that, the piezoelectric patch 100 may also be in other shape, such as rectangular shape, polygonal shape, and other regular geometric shape.

In one embodiment, referring to FIG. 1, the elastic element 210 includes a first spring 211, a bottom of the first spring 211 is fixed to the top surface of the mass block 220, and a central axis of the first spring 211 is coincided with the central axis of the mass block 220. The initial state of the first spring 211 may be a natural stretchable state, and may be a compressed state, however, the applied force exerted on the vibration trigger structure 300 by the first spring 211 and the mass block 220 as a whole is much less than the trigger threshold.

In one embodiment, referring to FIG. 8 and FIG. 9, the elastic element 210 further includes a stressed member 411 that can be resilient after being pressed. A top of the first spring 211 is engaged with a bottom surface of the stressed member 411. The stressed member 411 drives the first spring 211 to be deformed after being pressed, after the force exerted on the stressed member 411 is released, the first spring 211 drives the mass block 220 to perform damped vibration under the action of the elasticity thereof.

The first spring 211 can be arranged to be integrated with the stressed member 411. As an alternative, the first spring 211 and the stressed member 411 can be assembled and secured in the manner of separate structure. For example, the first spring 211 and the stressed member 411 can be assembled and secured by clamping, welding, etc. The bottom of the first spring 211 can be fixed to the mass block 220 by welding. In particular, the top surface of the mass block 220 is provided with an accommodation groove 221 to accommodate the first spring 211, and the bottom of the first spring 211 is inserted and fixed into the slot 221 through welding, so that a connection strength between the first spring 211 and the mass block 220 is increased, and the bottom of the first spring 211 is not prone to be distorted and deformed. The coincidence of the center axis of the first spring 211 and the central axis of the mass block 220 can be kept during a long-term use.

In one embodiment, referring to FIG. 8 and FIG. 9, the bottom surface of the stressed member 411 is provided with a convex block 413, and the top end of the first spring 211 is fixed to an outer circumference of the convex block 413. The convex block 413 can be arranged at the center of the bottom surface of the stressed member 411, and the convex block 413 is assembled with the first spring 211 in a snap-fit manner, an operation of assembling of the convex block 413 and the first spring 211 is simple.

In one embodiment, referring to FIG. 8 and FIG. 9, the self-generation device further includes a housing 400, the stressed member 411 is arranged at a top surface of the housing 400, the piezoelectric patch 100 and the vibration structure 200 are accommodated in the housing 400. An inner bottom side of the housing 400 is provided with a mounting base 430, the mounting base 430 is recessed, and a recess 431 is formed. The circumference of the piezoelectric patch 100 is fixed to the mounting base 430, a wall of the recess 431 and the piezoelectric patch 100 are enclosed to form the deformation space. An inner wall of the recess 431 adjacent to the opening of the recess 431 may be provided with an annular mounting step, and the peripheral edges of the piezoelectric patch 100 may be fixed to the mounting step by bonding, so that the piezoelectric patch 100 and the wall of the recess 431 are enclosed to form the deformation space for accommodating the deformations of the stressed piezoelectric patch 100.

In one embodiment, referring to FIG. 8 and FIG. 9, the stressed member 411 is a force panel 412 arranged on the top surface of the housing 400, and the force panel 412 is resilient. The panel 412 can be, but is not limited to, a silicone panel, a plastic panel or an elastic metal panel, and the panel 412 can be quickly restored to its original state after being pressed by force.

As shown in Figure 8, the housing 400 includes a surface shell 410 and a bottom shell 420, the surface shell 410 has a hollow structure, one end of the force panel 412 is connected to the surface shell 410, so that the force panel 412 can be restored to its original state after the force panel 412 is pressed in the direction towards the interior of the housing 400, the bottom shell 420 is provided with a mounting base 430 for mounting the piezoelectric patch 100. A circuit board 440 is arranged at the side of the bottom shell 420, an energy storage module is arranged on the circuit board 440, the circuit board 440 is conductive through the wire and the positive electrode and the negative electrode of the piezoelectric patch 100.

In one embodiment, the stressed member 411 is a button arranged on the top surface of the housing 400, and a resilient elastic element is provided between the button and the housing 400, the resilient elastic element can restore to its original position after the button is pressed. That is, the button is movably arranged on the housing 400, and the button can be resilient due to the elastic force generated by the resilient elastic element, after the button is pressed.

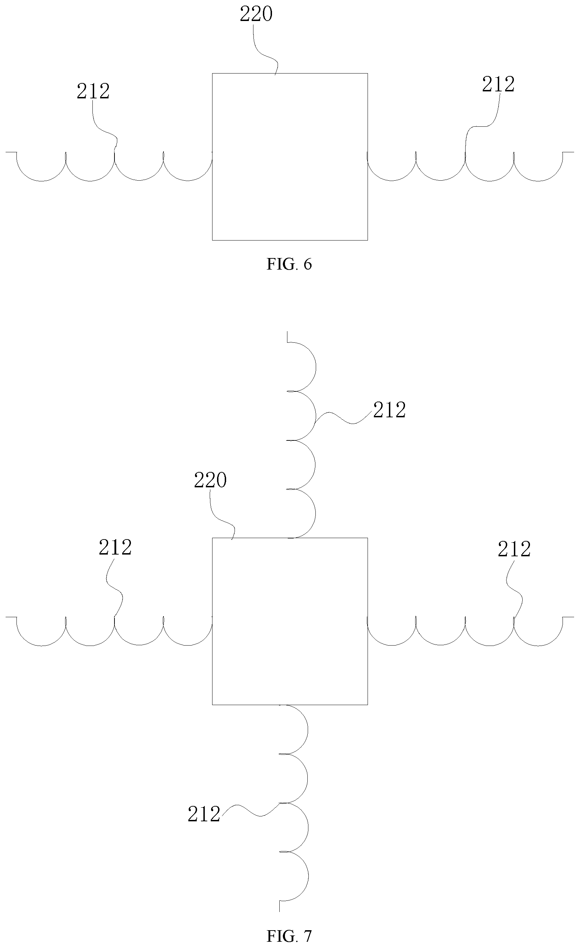

In one embodiment, referring to FIG. 6 and FIG. 7, the elastic element 210 includes a plurality of second springs 212, one end of each second spring 212 is connected to the mass block 220, the plurality of second springs 212 are arranged horizontally or diagonally upwards, and the plurality of second spring 212 are arranged to be evenly distributed around the circumference of the mass block 220. One end of each second spring 212 may be welded to a side wall of the mass block 220. When the plurality of second springs 212 are arranged horizontally or diagonally upwards, these second springs 212 may be arranged to be distributed around the circumference of the mass block 220 evenly and at intervals, so that forces exerted on the mass block 220 in all directions are balanced, and the mass block 220 is enabled to generate regular vibrations, that is, the mass block 220 can generate vibrations that approximate to a sine wave in shape.

In one embodiment, the mass block 220 is a metal block or a concrete block. The mass block 220 may be cylindrical, spherical, ellipsoidal, or other shape; the weight of the mass block 220 is less than the trigger threshold of the vibration trigger structure 300, that is, the weight of the mass block 220 would not trigger the vibration trigger structure 300 to generate effective deformation when the elastic element 210 does not receive an applied force. When the mass block 220 is made of metal, in particular, the mass block 220 may be made from a zinc alloy block, a copper block, etc. When the mass block 220 is made of the cement block, the cost of the product can be reduced, and a production process of the cement block is mature, and it is much easier to produce the cement block.

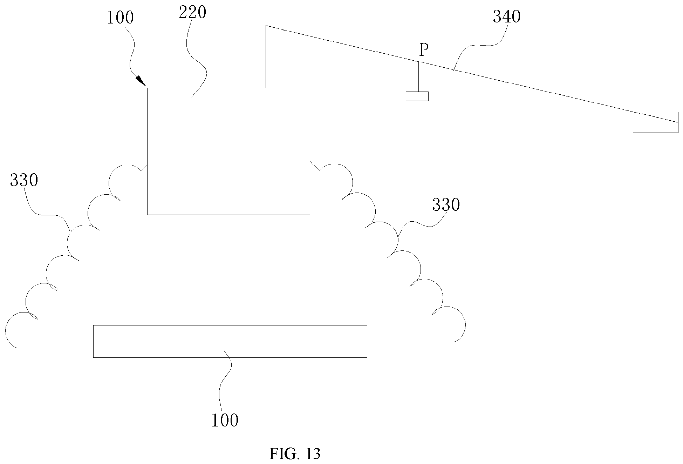

Referring to FIG. 12 and FIG. 13, a self-generation device provided in this embodiment of the present application includes a piezoelectric patch 100, a vibration structure 200 and a vibration trigger structure 300. A bottom of the piezoelectric patch 100 is provided with a deformation space for accommodating the deformed piezoelectric patch 100. The vibration structure 200 includes a mass block 220 which is arranged at the top of the piezoelectric patch 100. The vibration trigger structure 300 has a triggered threshold and can be resilient after being pressed. The vibration trigger structure 300 includes an elastic element 330 and a lever 340; one end of the elastic element 330 is connected to the mass block 220, and the elastic element 330 includes a plurality of springs, and the plurality of springs can be arranged to be distributed around the circumference of the mass block 220 evenly and at intervals. When two springs are used, the two springs are symmetrically arranged on opposite sides of the mass block 220. The elastic element 330 may also be one spring which is vertically disposed, and one end of the spring is attached to a top surface of the mass block 220. One end of the lever 340 is connected to a top surface of the mass block 220. When a driving force exerted on the other end of the lever 340 is greater than the trigger threshold, the lever 340 is rotated around a pivot point P and drives the mass block 220 to move upwards. After the force exerted on the other end of the lever 340 is released, the lever 340 and the elastic element 330 drive the mass block 220 to generate vibrations. The vibrations of the mass block 220 cause the piezoelectric patch 100 to receive an alternating load and generate multiple deformations in the deformation space, so that the mechanical energy generated due to the vibrations of the mass block 220 can be converted into electrical energy. The elastic element 330 can enable the mass block 220 to be restored to its original position after the vibrations disappear. In one embodiment, FIG. 12 illustrates an initial state of the mass block 220 without movement, the bottom surface of the mass block 220 is in contact with the top surface of the piezoelectric patch 100, a top of the other end of the lever 340 may be provided with a button, when a certain force is exerted on the button, the lever 340 can be triggered to be rotated around the pivot point P and drive the mass block 220 to be elevated, so that the mass block 220 leaves away from the piezoelectric patch 100. As shown in Figure 13, after the force exerted on the button is released, the mass block 220 generates vibrations under the driving of the lever 340 and the elastic element 330. The mass block 220 are pressed against the piezoelectric patch 100 for many times, thereby causing the piezoelectric patch 100 to generate multiple deformations in the deformation space until movement of the mass block 220 is stopped. During the vibration process, the mechanical energy generated due to the vibrations of the mass block 220 is converted into the electrical energy, and the electrical energies generated due to the multiple deformations of the piezoelectric patch 100 can be output to an energy storage device through wires. During the vibration process. During the vibration process, in one aspect, the elastic element 330 provides elastic force for causing the mass block 220 to be vibrated, in another aspect, the elastic element 330 further provides a restoring force for enabling the mass block 220 to restore to its original position.

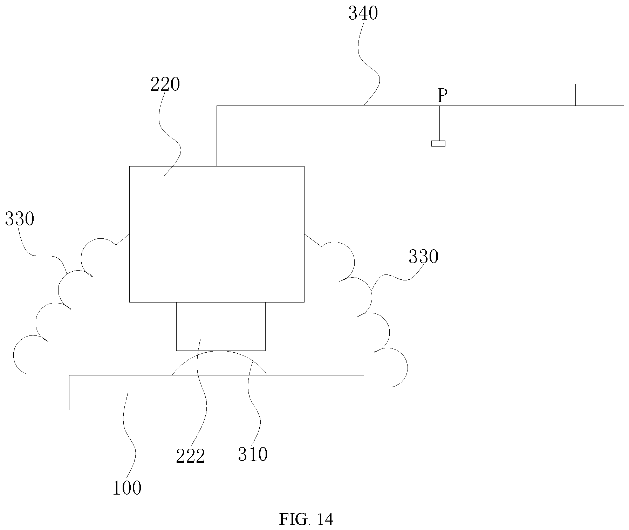

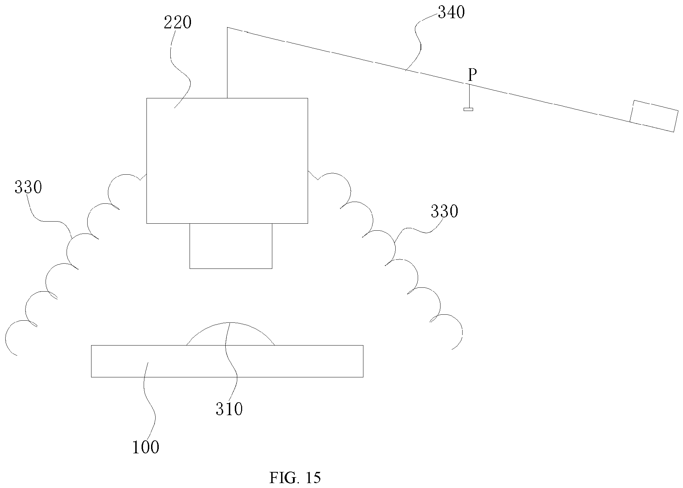

In one embodiment, referring to FIG. 14 and FIG. 15, the self-generation device further includes a metal dome 310 fixed to the top surface of the piezoelectric patch 100, a central part of the metal dome 310 is protrudes towards the mass block 220 to form an arc-shaped protrusion 323; a position of a bottom surface of the mass block 220 corresponding to the arc-shaped protrusion 323 is convexly provided with a cylindrical lug boss 222, a cross-sectional area of the lug boss 222 is smaller than a cross-sectional area of a widest part of the arc-shaped protrusion 323. The lug boss 222 abuts against the arc-shaped protrusion 323, and the arc-shaped protrusion 323 makes a deformational displacement when the applied force reaches the trigger threshold, and can be rebounded upwards after the applied force is released. The metal dome 310 is arranged at the top surface of the piezoelectric patch 100, when the mass block 220 is driven by the vibration trigger structure 300 to generate vibrations, the bottom surface of the mass block 220 abuts against the arc-shaped protrusion 323 of the metal dome 310. The arc-shaped protrusion 323 generates vibrations when the force exerted on the arc-shaped protrusion 323 reaches the trigger threshold. In other words, the vibration trigger structure 300 generates two times of vibrations (i.e., the vibrations triggered by the lever 340 and the elastic element 330, and the vibrations triggered by the metal dome 310) after accumulation of forces. The arrangement of the metal dome 310 can further improve the efficiency of converting mechanical energy into electrical energy, and further facilitate the adjustment of the parameters of the self-generation device, so that the components of the self-generation device can be flexibly configured and become applicable, and the applicability of the self-generation device is improved.

## Claims

1. A self-generation device, comprising:
a piezoelectric patch (100), wherein a bottom of the piezoelectric patch (100) is provided with a deformation space for accommodating the deformed piezoelectric patch (100);
a vibration structure (200) comprising an elastic element (210) and a mass block (220) connected to the elastic element (210); and
a vibration trigger structure (300) which has a trigger threshold and is resilient, wherein the vibration trigger structure (300) is arranged between the piezoelectric patch (100) and the mass block (220), and a bottom surface of the mass block (220) is in contact with the vibration trigger structure (300);
wherein the elastic element (210) is capable of driving the vibration trigger structure (300) to press against the piezoelectric patch (100) through the mass block (220) after receiving a force; when a driven force exerted on the vibration trigger structure (300) is greater than the trigger threshold, the vibration structure (200) generates vibrations, so that the piezoelectric patch (100) receives an alternating load and generates multiple deformations in the deformation space in order to convert a mechanical energy generated due to vibrations of the mass block (220) into an electrical energy;
a central part of the vibration trigger structure (300) is provided with an arc-shaped protrusion (323), the arc-shaped protrusion (323) is deformable when the mass block (220) is pressed against the vibration trigger structure (300); the arc-shaped protrusion (323) makes a deformational displacement when the applied force exerted on the arc-shaped protrusion (323) reaches the trigger threshold, and then is rebounded upwards when the applied force is released, thereby generating a force that causes the mass block (220) to generate the vibrations at an equilibrium point;
**characterized in that**, the vibration trigger structure (300) is a metal elastic sheet (320) suspended above the piezoelectric patch (100), the metal elastic sheet (320) is bent in a direction away from the piezoelectric patch (100) so as to form a second convex bump (322), a central part of the second convex bump (322) is bent towards the piezoelectric patch (100) so as to form the arc-shaped protrusion (323), and the arc-shaped protrusion (323) is in contact with the piezoelectric patch (100).

2. The self-generation device according to claim 1, **characterized in that**, the vibration trigger structure (300) is a metal dome (310) fixed to a top surface of the piezoelectric patch (100), the arc-shaped protrusion (323) is formed at a central part of the metal dome (310), and the arc-shaped protrusion (323) is curved in a direction away from the piezoelectric patch (100) and abuts against the bottom surface of the mass block (220).

3. The self-generation device according to claim 1, **characterized in that**, the vibration trigger structure (300) is a metal elastic sheet (320) suspended above the piezoelectric patch (100), the metal elastic sheet (320) is bent in a direction away from the piezoelectric patch (100) so as to form a first convex bump (321), and a central part of the first convex bump (321) is bent in a direction away from the piezoelectric patch (100) so as to form the arc-shaped protrusion (323).

4. The self-generation device according to claim 1, **characterized in that**, a position of the bottom surface of the mass block (220) corresponding to of the arc-shaped protrusion (323) is provided with a lug boss (222), the lug boss (222) has a cross-sectional area smaller than a cross-sectional area of a widest part of the arc-shaped protrusion (323).

5. The self-generation device according to claim 1, **characterized in that**, a cross-section of the piezoelectric patch (100) in a thickness direction is circular, a central axis of the piezoelectric patch (100), a central axis of the elastic element (210) and a central axis of the vibration trigger structure (300) are coincided.

6. The self-generation device according to claim 1, **characterized in that**, the elastic element (210) comprises a first spring (211), a bottom end of the first spring (211) is fixed to a top surface of the mass block (220), and a central axis of the first spring (211) is coincided with a central axis of the mass block (220).

7. The self-generation device according to claim 5, **characterized in that**, the elastic element (210) further comprises a stressed member (411) which is resilient after being pressed, a top end of the first spring (211) is engaged with a bottom surface of the stressed member (411), the stressed member (411) drives the first spring (211) to be deformed after being pressed, and the first spring (211) drives the mass block (220) to perform a damped vibration under an action of an elasticity thereof, after the force applied on the stressed member (411) is released.

8. The self-generation device according to claim 7, **characterized in that**, a bottom surface of the stressed member (411) is provided with a convex block (413), and the top end of the first spring (211) is sleeved on and secured to an outer circumference of the convex block (413).

9. The self-generation device according to claim 7, **characterized in that**, the self-generation device further comprises a housing (400), the stressed member (411) is arranged on a top surface of the housing (400), the piezoelectric patch (100) and the vibration structure (200) are received in the housing (400), an inner bottom surface of the housing (400) is provided with a mounting base (430), the mounting base (430) is recessed, so that a recess (431) is formed, a periphery of the piezoelectric patch (100) is fixed on the mounting base (430), and a wall of the recess (431) and the piezoelectric patch (100) are enclosed to form the deformation space.

10. The self-generation device according to claim 9, **characterized in that**, the stressed member (411) is a force panel (412) arranged on the top surface of the housing (400), and the force panel (412) is resilient.

11. The self-generation device according to claim 9, **characterized in that**, the stressed member (411) is a button arranged on the top surface of the housing (400), and a resilient elastic element for restoration of the button after the button is pressed is provided between the button and the housing (400).

12. The self-generation device according to claim 1, **characterized in that**, the elastic element (210) comprises a plurality of second springs (212), one end of each of the plurality of second springs (212) is connected to the mass block (220), and the plurality of second springs (212) are distributed horizontally or diagonally upwards; wherein the plurality of second springs (212) are arranged to be distributed uniformly around a circumference of the mass block (220).

13. The self-generation device according to claim 1, **characterized in that**, the mass block (220) is a metal block or a cement block.

## Patentansprüche

1. Selbsterzeugende Vorrichtung, umfassend:
ein piezoelektrisches Patch (100), wobei ein Boden des piezoelektrischen Patchs (100) mit einem Verformungsbereich zum Aufnehmen des verformten piezoelektrischen Patchs (100) versehen ist;
eine Vibrationsstruktur (200), die ein elastisches Element (210) und einen Masseblock (220) umfasst, der mit dem elastischen Element (210) verbunden ist; und
eine Vibrationsauslösestruktur (300), die eine Auslöseschwelle hat und federnd ist, wobei die Vibrationsauslösestruktur (300) zwischen dem piezoelektrischen Patch (100) und dem Masseblock (220) angeordnet ist und eine untere Fläche des Masseblocks (220) in Kontakt mit der Vibrationsauslösestruktur (300) ist;
wobei das elastische Element (210) in der Lage ist, die Vibrationsauslösestruktur (300) so anzutreiben, dass sie nach Aufnahme einer Kraft durch den Masseblock (220) gegen das piezoelektrische Patch (100) drückt; wenn eine auf die Vibrationsauslösestruktur (300) ausgeübte angetriebene Kraft größer als der Auslöseschwellenwert ist, die Vibrationsstruktur (200) Vibrationen erzeugt, so dass das piezoelektrische Patch (100) eine wechselnde Belastung aufnimmt und mehrere Verformungen im Verformungsbereich erzeugt, um eine durch die Vibrationen des Masseblocks (220) erzeugte mechanische Energie in eine elektrische Energie umzuwandeln;
ein zentraler Teil der Vibrationsauslösestruktur (300) mit einem bogenförmigen Vorsprung (323) versehen ist, der bogenförmige Vorsprung (323) verformbar ist, wenn der Masseblock (220) gegen die Vibrationsauslösestruktur (300) gedrückt wird; der bogenförmige Vorsprung (323) eine Verformungsverschiebung durchführt, wenn die auf den bogenförmigen Vorsprung (323) ausgeübte Kraft den Auslöseschwellenwert erreicht, und dann nach oben zurückfedert, wenn die ausgeübte Kraft nachlässt, wodurch eine Kraft erzeugt wird, die den Masseblock (220) veranlasst, die Schwingungen an einem Gleichgewichtspunkt zu erzeugen;
**dadurch gekennzeichnet, dass** die Vibrationsauslösestruktur (300) ein elastisches Metallblech (320) ist, das über dem piezoelektrischen Patch (100) hängt, wobei das elastische Metallblech (320) in einer Richtung weg von dem piezoelektrischen Patch (100) gebogen ist, um eine zweite konvexe Erhebung (322) zu bilden, ein zentraler Teil der zweiten konvexen Erhebung (322) in Richtung des piezoelektrischen Patchs (100) gebogen ist, um den bogenförmigen Vorsprung (323) zu bilden, und der bogenförmige Vorsprung (323) in Kontakt mit dem piezoelektrischen Patch (100) ist.

2. Selbsterzeugende Vorrichtung nach Anspruch 1, **dadurch gekennzeichnet, dass** die Vibrationsauslösestruktur (300) eine Metallkuppel (310) ist, die an einer oberen Fläche des piezoelektrischen Patchs (100) befestigt ist, der bogenförmige Vorsprung (323) an einem zentralen Teil der Metallkuppel (310) ausgebildet ist, und der bogenförmige Vorsprung (323) in einer Richtung weg von dem piezoelektrischen Patch (100) gekrümmt ist und an der unteren Fläche des Masseblocks (220) anliegt.

3. Selbsterzeugende Vorrichtung nach Anspruch 1, **dadurch gekennzeichnet, dass** die Vibrationsauslösestruktur (300) ein elastisches Metallblech (320) ist, das über dem piezoelektrischen Patch (100) hängt, wobei das elastische Metallblech (320) in einer Richtung weg von dem piezoelektrischen Patch (100) gebogen ist, um eine erste konvexe Erhebung (321) zu bilden, und ein zentraler Teil der ersten konvexen Erhebung (321) in einer Richtung weg von dem piezoelektrischen Patch (100) gebogen ist, um den bogenförmigen Vorsprung (323) zu bilden.

4. Die selbsterzeugende Vorrichtung nach Anspruch 1, **dadurch gekennzeichnet, dass** eine Position der unteren Fläche des Masseblocks (220), die dem bogenförmigen Vorsprung (323) entspricht, mit einem Ansatzvorsprung (222) versehen ist, wobei der Ansatzvorsprung (222) eine Querschnittsfläche hat, die kleiner ist als eine Querschnittsfläche eines breitesten Teils des bogenförmigen Vorsprungs (323).

5. Die selbsterzeugende Vorrichtung nach Anspruch 1, **dadurch gekennzeichnet, dass** ein Querschnitt des piezoelektrischen Patchs (100) in einer Dickenrichtung kreisförmig ist, eine Mittelachse des piezoelektrischen Patchs (100), eine Mittelachse des elastischen Elements (210) und eine Mittelachse der Vibrationsauslösestruktur (300) übereinstimmen.

6. Selbsterzeugende Vorrichtung nach Anspruch 1, **dadurch gekennzeichnet, dass** das elastische Element (210) eine erste Feder (211) umfasst, ein unteres Ende der ersten Feder (211) an einer oberen Fläche des Masseblocks (220) befestigt ist und eine Mittelachse der ersten Feder (211) mit einer Mittelachse des Masseblocks (220) übereinstimmt.

7. Selbsterzeugende Vorrichtung nach Anspruch 5, **dadurch gekennzeichnet, dass** das elastische Element (210) ferner ein belastetes Element (411) umfasst, das nachdem es gepresst wurde, federnd ist, ein oberes Ende der ersten Feder (211) mit einer untere Fläche des belasteten Elements (411) in Eingriff steht, das belastete Element (411) die erste Feder (211) antreibt, um nachdem es gepresst wurde, verformt zu werden, und die erste Feder (211) den Masseblock (220) antreibt, um eine gedämpfte Vibration unter einer Einwirkung seiner Elastizität auszuführen, nachdem die auf das belastete Element (411) ausgeübte Kraft gelöst wurde.

8. Selbsterzeugende Vorrichtung nach Anspruch 7, **dadurch gekennzeichnet, dass** eine untere Fläche des belasteten Elements (411) mit einem konvexen Block (413) versehen ist und das obere Ende der ersten Feder (211) auf einen Außenumfang des konvexen Blocks (413) aufgeschoben und daran befestigt ist.

9. Die selbsterzeugende Vorrichtung nach Anspruch 7, **dadurch gekennzeichnet, dass** die selbsterzeugende Vorrichtung ferner ein Gehäuse (400) umfasst, das belastete Element (411) auf einer oberen Fläche des Gehäuses (400) angeordnet ist, das piezoelektrische Patch (100) und die Vibrationsstruktur (200) in dem Gehäuse (400) aufgenommen sind, eine innere untere Fläche des Gehäuses (400) mit einer Grundplatte (430) versehen ist, die Grundplatte (430) ausgespart ist, so dass eine Aussparung (431) gebildet wird, ein Umfang des piezoelektrischen Patchs (100) an der Grundplatte (430) befestigt ist, und eine Wand der Aussparung (431) und das piezoelektrische Patch (100) eingeschlossen sind, um den Verformungsbereich zu bilden.

10. Selbsterzeugende Vorrichtung nach Anspruch 9, **dadurch gekennzeichnet, dass** das belastete Element (411) ein Kraftpaneel (412) ist, das auf der oberen Fläche des Gehäuses (400) angeordnet ist, und das Kraftpaneel (412) federnd ist.

11. Die selbsterzeugende Vorrichtung nach Anspruch 9, **dadurch gekennzeichnet, dass** das belastete Element (411) ein Knopf ist, der auf der oberen Fläche des Gehäuses (400) angeordnet ist, und ein federndes elastisches Element zur Rückstellung des Knopfes nach dem Drücken des Knopfes zwischen dem Knopf und dem Gehäuse (400) vorgesehen ist.

12. Die selbsterzeugende Vorrichtung nach Anspruch 1, **dadurch gekennzeichnet, dass** das elastische Element (210) eine Vielzahl von zweiten Federn (212) umfasst, ein Ende jeder der Vielzahl von zweiten Federn (212) mit dem Masseblock (220) verbunden ist, und die Vielzahl von zweiten Federn (212) horizontal oder diagonal aufwärts verteilt ist; wobei die Vielzahl von zweiten Federn (212) so angeordnet ist, dass sie gleichmäßig um einen Umfang des Masseblocks (220) verteilt sind.

13. Selbsterzeugende Vorrichtung nach Anspruch 1, **dadurch gekennzeichnet, dass** der Masseblock (220) ein Metallblock oder ein Zementblock ist.

## Revendications

1. Dispositif auto-générateur, comprenant:
un patch piézoélectrique (100), dans lequel un fond du patch piézoélectrique (100) est pourvu d'un espace de déformation pour accueillir le patch piézoélectrique (100) déformé;
une structure de vibration (200) comprenant un élément élastique (210) et un bloc de masse (220) relié à l'élément élastique (210); et
une structure de déclenchement de vibration (300) qui a un seuil de déclenchement et est résiliente, dans laquelle la structure de déclenchement de vibration (300) est arrangée entre le patch piézoélectrique (100) et le bloc de masse (220), et une surface inférieure du bloc de masse (220) est en contact avec la structure de déclenchement de vibration (300);
dans lequel l'élément élastique (210) est capable d'entraîner la structure de déclenchement de vibration (300) à presser contre le patch piézoélectrique (100) à travers le bloc de masse (220) après avoir reçu une force; lorsqu'une force entraînée exercée sur la structure de déclenchement de vibration (300) est supérieure au seuil de déclenchement, la structure de vibration (200) génère des vibrations de sorte que le patch piézoélectrique (100) reçoit une charge alternée et génère des déformations multiples dans l'espace de déformation afin de convertir une énergie mécanique générée par les vibrations du bloc de masse (220) en une énergie électrique;
une partie centrale de la structure de déclenchement de vibration (300) est pourvue d'une protubérance en forme d'arc (323), la protubérance en forme d'arc (323) est déformable lorsque le bloc de masse (220) est pressé contre la structure de déclenchement de vibration (300); la protubérance en forme d'arc (323) effectue un déplacement de déformation lorsque la force appliquée exercée sur la protubérance en forme d'arc (323) atteint le seuil de déclenchement, puis elle rebondit vers le haut lorsque la force appliquée est relâchée, générant ainsi une force qui amène le bloc de masse (220) à générer les vibrations à un point d'équilibre;
**caractérisé en ce que** la structure de déclenchement de vibration (300) est une feuille métallique élastique (320) suspendue sur le patch piézoélectrique (100), la feuille métallique élastique (320) est pliée dans une direction opposée au patch piézoélectrique (100) de manière à former une seconde bosse convexe (322), une partie centrale de la seconde bosse convexe (322) est pliée en direction du patch piézoélectrique (100) de manière à former la protubérance en forme d'arc (323), et la protubérance en forme d'arc (323) est en contact avec le patch piézoélectrique (100).

2. Dispositif auto-générateur selon la revendication 1, **caractérisé en ce que** la structure de déclenchement de vibration (300) est un dôme métallique (310) fixé à une surface supérieure du patch piézoélectrique (100), la protubérance en forme d'arc (323) est formée dans une partie centrale du dôme métallique (310), et la protubérance en forme d'arc (323) est courbée dans une direction opposée au patch piézoélectrique (100) et vient en butée contre la surface inférieure du bloc de masse (220).

3. Dispositif auto-générateur selon la revendication 1, **caractérisé en ce que** la structure de déclenchement de vibration (300) est une feuille élastique métallique (320) suspendue sur le patch piézoélectrique (100), la feuille élastique métallique (320) est pliée dans une direction opposée au patch piézoélectrique (100) de manière à former une première bosse convexe (321), et une partie centrale de la première bosse convexe (321) est pliée dans une direction opposée au patch piézoélectrique (100) de manière à former la protubérance en forme d'arc (323).

4. Dispositif auto-générateur selon la revendication 1, **caractérisé en ce qu'**une position de la surface inférieure du bloc de masse (220) correspondant à la protubérance en forme d'arc (323) est pourvue d'un bossage (222), le bossage (222) ayant une surface de section transversale inférieure à la surface de section transversale de la partie la plus large de la protubérance en forme d'arc (323).

5. Dispositif auto-générateur selon la revendication 1, **caractérisé en ce qu'**une section transversale du patch piézoélectrique (100) dans une direction d'épaisseur est circulaire, un axe central du patch piézoélectrique (100), un axe central de l'élément élastique (210) et un axe central de la structure de déclenchement de vibration (300) coïncident.

6. Dispositif auto-générateur selon la revendication 1, **caractérisé en ce que** l'élément élastique (210) comprend un premier ressort (211), une extrémité inférieure du premier ressort (211) est fixée à une surface supérieure du bloc de masse (220), et un axe central du premier ressort (211) coïncide avec un axe central du bloc de masse (220).

7. Dispositif auto-générateur selon la revendication 5, **caractérisé en ce que** l'élément élastique (210) comprend en outre un élément sollicité (411) qui est résilient après avoir été pressé, une extrémité supérieure du premier ressort (211) est engagée avec une surface inférieure de l'élément sollicité (411), l'élément sollicité (411) entraîne le premier ressort (211) à se déformer après avoir été pressé, et le premier ressort (211) entraîne le bloc de masse (220) à effectuer une vibration amortie sous l'action de son élasticité, après que la force appliquée sur l'élément sollicité (411) a été relâchée.

8. Dispositif auto-générateur selon la revendication 7, **caractérisé en ce qu'**une surface inférieure de l'élément sollicité (411) est pourvue d'un bloc convexe (413), et que l'extrémité supérieure du premier ressort (211) est manchonnée et fixée à une circonférence extérieure du bloc convexe (413).

9. Dispositif auto-générateur selon la revendication 7, **caractérisé en ce que** le dispositif auto-générateur comprend en outre un boîtier (400), l'élément sollicité (411) est arrangé sur une surface supérieure du boîtier (400), le patch piézoélectrique (100) et la structure de vibration (200) sont reçus dans le boîtier (400), une surface inférieure intérieure du boîtier (400) est pourvue d'une base de montage (430), la base de montage (430) est évidée, de sorte qu'un évidement (431) est formé, une périphérie du patch piézoélectrique (100) est fixée sur la base de montage (430), et une paroi de l'évidement (431) et le patch piézoélectrique (100) sont entourés de manière à former l'espace de déformation.

10. Dispositif auto-générateur selon la revendication 9, **caractérisé en ce que** l'élément sollicité (411) est un panneau de force (412) arrangé sur la surface supérieure du boîtier (400), et le panneau de force (412) est résilient.

11. Dispositif auto-générateur selon la revendication 9, **caractérisé en ce que** l'élément sollicité (411) est un bouton arrangé sur la surface supérieure du boîtier (400), et un élément élastique résilient pour la restauration du bouton après que le bouton est pressé est prévu entre le bouton et le boîtier (400).

12. Dispositif auto-générateur selon la revendication 1, **caractérisé en ce que** l'élément élastique (210) comprend une pluralité de seconds ressorts (212), une extrémité de chacun de la pluralité de seconds ressorts (212) est reliée au bloc de masse (220), et la pluralité de seconds ressorts (212) est distribuée horizontalement ou diagonalement vers le haut; la pluralité de seconds ressorts (212) étant arrangée pour être distribuée uniformément autour d'une circonférence du bloc de masse (220).

13. Dispositif auto-générateur selon la revendication 1, **caractérisé en ce que** le bloc de masse (220) est un bloc métallique ou un bloc de ciment.
